# EUROPEAN PATENT APPLICATION

(11) **EP 4 773 172 A1**
(43) Date of publication of application: **08.07.2026**
(21) Application number: 24857464.2
(22) Date of filing: 01.07.2024
(51) Int. Cl.: H01L 21/56, B29C 43/18, B29C 43/32, H01L 23/29, H01L 23/31

(54) **COMPRESSION MOLDING APPARATUS AND COMPRESSION MOLDING METHOD**

(30) Priority: 30.08.2023 JP 2023140326
(71) Applicant: Yamaha Robotics Co., Ltd., Musashimurayama-shi, Tokyo 208-8585 (JP)
(72) Inventor: WAKUI, Masaaki, Chikuma-shi, Nagano 389-0898 (JP); KAWAGUCHI, Makoto, Chikuma-shi, Nagano 389-0898 (JP)
(74) Representative: Becker, Eberhard
(86) International application number: PCT/JP2024/023701
(87) International publication number: WO 2025/047093

(57) **Abstract**

The purpose of the present invention is: to realize a compression molding apparatus and a compression molding method capable of preventing the occurrence of molding failure and forming a molded article having a resin part with thin thickness; to facilitate handling of the sealing resin before resin sealing; to prevent the occurrence of loss due to cracks during handling; and further to reduce the manufacturing cost and the size of the apparatus. As a solution, a compression molding apparatus (1) according to the present invention uses a sealing mold (202) having an upper mold (204) and a lower mold (206) to seal a workpiece (W) with a sealing resin (R) to thereby process the workpiece (W) into a molded product (Wp), wherein a base resin (Rm) in a state where a carrier (C) fixed thereto is used as the sealing resin (R). The compression molding apparatus (1) comprises a carrier peeling device (16) that peels the carrier (C) from the molded product (Wp).

## Description

### Technical Field

The invention relates to a compression molding apparatus and a compression molding method.

### Related Art

As an example of a resin sealing apparatus and a resin sealing method for sealing a work having an electronic component with a sealing resin and processing it into a molded product, a compression molding method is known.

The compression molding method is a technology for resin sealing by supplying a predetermined amount of sealing resin to a sealing area (cavity) provided in a sealing mold configured to include an upper mold and a lower mold, placing a work in the sealing area and clamping it with the upper mold and the lower mold. As an example, in the case of using a sealing mold having a cavity provided in the upper mold, a technology for supplying sealing resin collectively to a center position on the work and molding is known. On the other hand, there is known a technology for supplying a release film (hereinafter, may be simply referred to as "film") covering the mold surface including the cavity and sealing resin for molding in the case of using a sealing mold having a cavity provided in the lower mold (refer to Patent Document 1: Japanese Patent Application Laid-Open Publication No. 2019-145550).

### Citation List

### Patent Literature

Patent Document 1: Japanese Patent Application Laid-Open Publication No. 2019-145550

### SUMMARY OF INVENTION

### Technical Problem

Conventionally, there was also a view that there is an advantage in terms of preventing deformation of the work caused by contact due to the flow of sealing resin or the flow of wires, and a compression molding method in which the work is held in the upper mold, a cavity is provided in the lower mold, and sealing resin (as an example, granular resin) is supplied into the cavity was widely adopted (so-called lower cavity movable compression molding apparatus).

However, in a configuration in which the work is held in the upper mold and a cavity is provided in the lower mold, there was a problem that when the work is thin or large, holding in the upper mold is difficult and falling tends to occur. Moreover, in the case where granular resin is used as the sealing resin, in addition to the problem that dust is generated during molding due to friction between resin particles and the problem that handling is difficult, there was a problem that it is difficult to supply (spread) the sealing resin evenly to the entire area within the cavity provided in the lower mold, and uneven spreading tends to occur. Moreover, there was a problem that molding defects tend to occur in which air contained in gaps between particles during spreading of the sealing resin and gas components due to degassing from the sealing resin during melting remain as voids or the like in the molded product without escaping.

On the other hand, regardless of the arrangement of the cavity, in the case where solid resin having a certain shape, which is not granular resin or liquid resin, is used as the sealing resin, the following problems became apparent. Specifically, when attempting to form a thin molded product such that the resin thickness after resin sealing (specifically, the thickness of the resin portion at the upper position or lower position of the work after resin sealing) is 0.4 mm or less, the thickness of the sealing resin (solid resin) before resin sealing also has to be made thin. However, since the sealing resin (solid resin) before resin sealing is naturally in a state before full curing, it has low rigidity (is brittle) and weak strength, so a problem became apparent that breakage tends to occur extremely easily during handling (particularly during transport).

Moreover, in means for solving these problems, further reduction of manufacturing cost and miniaturization of the apparatus are required.

### Solution to Problem

The invention was made in view of the above circumstances, and aims to realize a compression molding apparatus and a compression molding method capable of preventing the occurrence of molding defects caused by uneven spreading of sealing resin, residual gas, and dust generation during molding, and capable of forming a molded product having a thin resin portion, while also facilitating handling of the sealing resin before resin sealing and preventing the occurrence of breakage during handling. Furthermore, the invention aims to reduce manufacturing cost and miniaturize the apparatus.

The invention solves the above problems by means of solutions as described below as one embodiment.

A compression molding apparatus according to one embodiment is a compression molding apparatus that seals a work with a sealing resin and processes it into a molded product using a sealing mold including an upper mold and a lower mold, in which as the sealing resin, a base resin in a state where a carrier is fixed thereto is used, and the compression molding apparatus includes a carrier peeling apparatus that peels the carrier from the molded product.

According to the above embodiment, it is possible to prevent the occurrence of molding defects caused by uneven spreading of sealing resin, residual gas, and dust generation during molding. Moreover, handling of the sealing resin can be facilitated, and even in the case of forming a thin molded product such that the thickness of the resin portion becomes 0.4 mm or less in particular, the occurrence of breakage of the sealing resin during handling can be prevented. Furthermore, by applying to a configuration in which a cavity is provided in the upper mold and a work is held in the lower mold, problems such as the work falling can be solved. Moreover, since the carrier may be peeled from the molded product and reused, reduction of manufacturing cost by reducing the number of parts and miniaturization of the apparatus mainly including the carrier storage part can be achieved.

Moreover, as the sealing resin, it is preferable that a solid resin formed into a predetermined shape with the carrier fixed thereto by tableting powder resin is used.

Moreover, it is preferable that a transport apparatus that performs transport for returning the carrier peeled from the molded product to an apparatus that performs forming of the sealing resin is provided.

Moreover, it is preferable that a cutting apparatus that cuts, in a thickness direction, within an area of the molded product where the carrier has been peeled, to remove an outer edge, is provided.

Moreover, a compression molding method according to one embodiment is a compression molding method that seals a work with a sealing resin and processes it into a molded product using a sealing mold including an upper mold and a lower mold, in which the method includes a resin preparation step of preparing, as the sealing resin, a base resin in a state where a carrier is fixed thereto; a transport step of transporting the sealing resin into the sealing mold; a resin sealing step of sealing the work with the sealing resin and processing it into the molded product by performing mold closing of the sealing mold; and a carrier peeling step of peeling the carrier from the molded product.

It is preferable that the method further includes a step of returning the carrier peeled from the molded product to an apparatus that performs forming of the sealing resin and reusing it when performing forming of the sealing resin.

Moreover, it is preferable that the method further includes a step of cutting, in a thickness direction, within an area of the molded product where the carrier has been peeled, to remove an outer edge.

### Effects of Invention

According to the invention, it is possible to prevent occurrence of molding defects caused by uneven spreading of sealing resin, residual gas, and dust generation during molding, and it is possible to realize a compression molding apparatus and a compression molding method capable of forming a molded product having a thin resin portion. Moreover, regarding the sealing resin before resin sealing, handling can be facilitated, and occurrence of breakage during handling can be prevented. Furthermore, reduction of manufacturing cost and miniaturization of the apparatus can be achieved.

### BRIEF DESCRIPTION OF DRAWINGS

[FIG. 1] FIG. 1 is a plan view showing an example of a compression molding apparatus according to an embodiment of the invention.
[FIG. 2] FIG. 2 is a side view showing an example of a first press apparatus of the compression molding apparatus according to a first embodiment of the invention.
[FIG. 3] FIG. 3 is a front cross-sectional view showing an example of a first mold of the compression molding apparatus according to the first embodiment of the invention.
[FIG. 4] FIG. 4 is a front cross-sectional view showing another example of the first mold of the compression molding apparatus according to the first embodiment of the invention.
[FIG. 5] FIG. 5 is a side view showing an example of a second press apparatus of the compression molding apparatus according to the first embodiment of the invention.
[FIG. 6] FIG. 6 is a front cross-sectional view showing an example of a second mold of the compression molding apparatus according to the first embodiment of the invention.
[FIG. 7] FIG. 7 is an explanatory diagram of a compression molding method according to the first embodiment of the invention.
[FIG. 8] FIG. 8 is an explanatory diagram following FIG. 7.
[FIG. 9] FIG. 9A is a plan view showing an example of a sealing resin used in the compression molding apparatus and the compression molding method according to the embodiment of the invention. FIG. 9B is a cross-sectional view taken along line A-A in FIG. 9A. FIG. 9C is a cross-sectional view showing another example of the sealing resin.
[FIG. 10] FIG. 10 is an explanatory diagram following FIG. 8.
[FIG. 11] FIG. 11 is an explanatory diagram following FIG. 10.
[FIG. 12] FIG. 12 is an explanatory diagram following FIG. 11.
[FIG. 13] FIG. 13 is an explanatory diagram following FIG. 12.
[FIG. 14] FIG. 14A to FIG. 14C are front cross-sectional views showing examples of molded products formed in the compression molding apparatus and the compression molding method according to the embodiment of the invention, in which FIG. 14A shows a state before performing a carrier peeling step, FIG. 14B shows a state after performing the carrier peeling step, and FIG. 14C shows a state after performing a cutting step.
[FIG. 15] FIG. 15 is a side view showing an example of a third press apparatus of the compression molding apparatus according to a second embodiment of the invention.
[FIG. 16] FIG. 16 is a side view showing an example of a third mold of the compression molding apparatus according to the second embodiment of the invention.
[FIG. 17] FIG. 17 is an explanatory diagram of the compression molding method according to the second embodiment of the invention.
[FIG. 18] FIG. 18 is an explanatory diagram following FIG. 17.
[FIG. 19] FIG. 19 is an explanatory diagram following FIG. 18.
[FIG. 20] FIG. 20 is an explanatory diagram of another example of the compression molding method according to the first embodiment of the invention.

### DESCRIPTION OF THE EMBODIMENTS

### [First embodiment]

### (Overall Configuration)

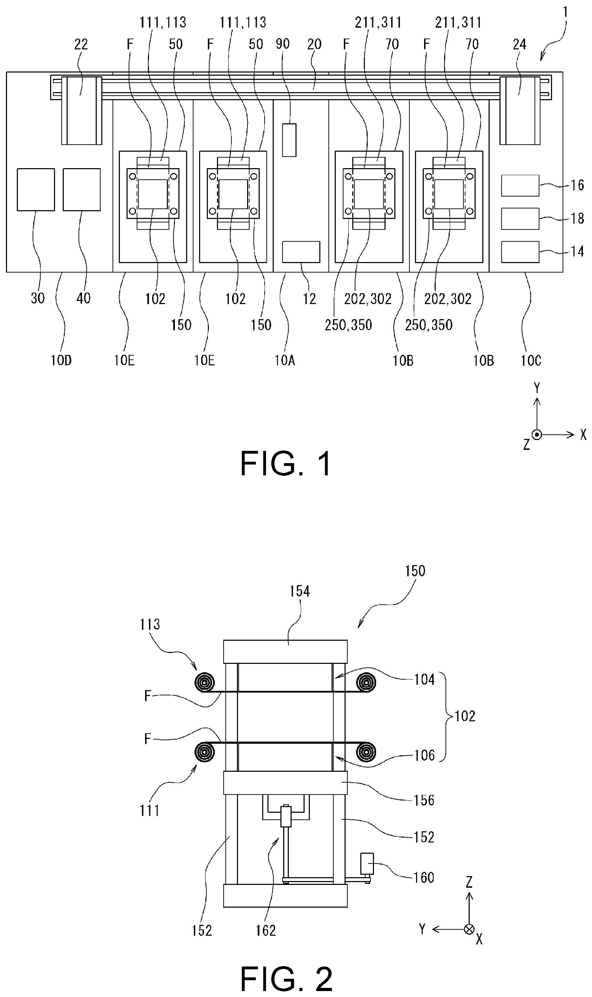

Hereinafter, the first embodiment of the invention is described in detail with reference to the drawings. FIG. 1 is a plan view (schematic diagram) showing an example of the compression molding apparatus 1 according to the present embodiment (this is a configuration diagram common to the second embodiment). For convenience of description, arrows in the figures indicate the left-right direction (X direction), the front-rear direction (Y direction), and the up-down direction (Z direction) of the compression molding apparatus 1. Moreover, in all figures for describing each embodiment, members having the same function are denoted by the same reference numerals, and repeated description thereof may be omitted.

The compression molding apparatus 1 according to the present embodiment is an apparatus that includes a sealing mold and performs resin sealing (compression molding) of a work (product to be molded) W using a sealing resin R.

First, the work W to be molded is configured to include electronic components. Examples of electronic components include coil sheets, semiconductor chips, MEMS chips, passive elements, heat dissipation plates, conductive members, spacers, and the like. The work W may be configured to consist of only electronic components, or may be configured to be mounted on a base material (wire bonding mounting, flip chip mounting, and the like). Examples of the base material include rectangular or circular plate-shaped members such as resin substrates, ceramics substrates, metal substrates, carrier plates, lead frames, wafers, and the like. Moreover, the number of electronic components constituting the work W is not particularly limited and is set to one or multiple.

In the present embodiment, as the sealing resin R, a base resin Rm in a state where a carrier C is fixed is used (details are described later). As an example, the carrier C is a plate-shaped member formed using a metal material (for example, copper, copper alloy, and the like) with a thickness dimension of approximately 0.1 mm to 0.5 mm, but is not limited thereto.

In the present embodiment, as the base resin Rm and the sealing resin R, a thermosetting resin (for example, a filler-containing epoxy-based resin and the like, but not limited thereto) is used. For the base resin Rm, a powder resin (powdery resin) that is a thermosetting resin (property) is preferably used (details are described later). However, the configuration is not limited thereto, and a configuration may be adopted in which granular resin, crushed resin, solid resin, liquid resin, or a resin combining multiple of these is used.

Moreover, as an example of the film F, a film material excellent in heat resistance, ease of peeling, flexibility, and extensibility, for example, PTFE (polytetrafluoroethylene), ETFE (polytetrafluoroethylene polymer), PET, FEP, fluorine-impregnated glass cloth, polypropylene, polyvinylidene chloride, and the like are preferably used. The film F is also used in forming the sealing resin R in the resin forming part 50 described later.

Next, an overview of the compression molding apparatus 1 according to the present embodiment is described. As shown in FIG. 1, the compression molding apparatus 1 includes, as main components, a base resin supply unit 10D that performs supply of the base resin Rm and the carrier C and the like, a resin forming unit 10E that performs formation of the sealing resin R and the like using the base resin Rm and the carrier C, a supply unit 10A that performs supply of the work W and the like, a press unit 10B that performs resin sealing of the work W and processing into the molded product Wp and the like, and a storage unit 10C that performs storage of the molded product Wp and the like. As an example, along the X direction in FIG. 1, the base resin supply unit 10D, the resin forming unit 10E, the supply unit 10A, the press unit 10B, and the storage unit 10C are arranged in this order. However, the configuration is not limited to the above, and the equipment configuration within the units, the number of units, the arrangement order of the units, and the like may be changed. For example, the supply unit 10A and the storage unit 10C may be arranged in mutually opposite positions in the X direction, or may be arranged to be consolidated at either one of the positions (not shown). Moreover, a configuration including units other than the above may be adopted (not shown).

Moreover, in the compression molding apparatus 1, a guide rail 20 is provided linearly across the units, and a transport apparatus (first loader) 22 that transports the work W and the sealing resin R (may also be used for transporting items other than the work W and the sealing resin R), as well as a transport apparatus (second loader) 24 that transports the molded product Wp (may also be used for transporting items other than the molded product Wp), are provided to be movable between predetermined units along the guide rail 20. However, the configuration is not limited to the above, and a configuration including a common (single) transport apparatus (loader) that transports the work W, the sealing resin R, the molded product Wp, and the like may be adopted (not shown). Moreover, the transport apparatus may be configured to include a robot hand or the like instead of a loader.

Moreover, in the compression molding apparatus 1, a control part 90 that performs operation control and the like of each mechanism in each unit is arranged in the supply unit 10A (a configuration in which it is arranged in other units may also be adopted).

### (Base Resin Supply Unit)

Next, the base resin supply unit 10D included in the compression molding apparatus 1 is described.

The base resin supply unit 10D includes a carrier supply part 30 that supplies the carrier C, and a base resin supply part 40 that supplies the base resin Rm. As an example, the carrier supply part 30 is configured to include a storage part (for example, a stocker or the like) in which multiple carriers C are stored (a pickup, a stage, or the like may be provided as appropriate). Moreover, the base resin supply part 40 is configured to include a dispenser that supplies the base resin Rm, a transport apparatus, and the like. When transporting the carrier C and the base resin Rm from the base resin supply unit 10D to the resin forming unit 10E, the first loader 22 may be used as the transport apparatus, or other transport apparatuses or the like (not shown) may be used (regarding the base resin Rm, direct spreading from the dispenser or the like may also be adopted).

### (Resin Forming Unit)

Next, the resin forming unit 10E included in the compression molding apparatus 1 is described.

The resin forming unit 10E includes a resin forming part 50 as an apparatus that forms the sealing resin R using the base resin Rm and the carrier C. In the present embodiment, two units of the resin forming unit 10E are provided (three or more units or one unit may also be adopted), and one resin forming part 50 (two or more units may also be adopted) is provided per one resin forming unit 10E (see FIG. 1). However, the configuration is not limited thereto.

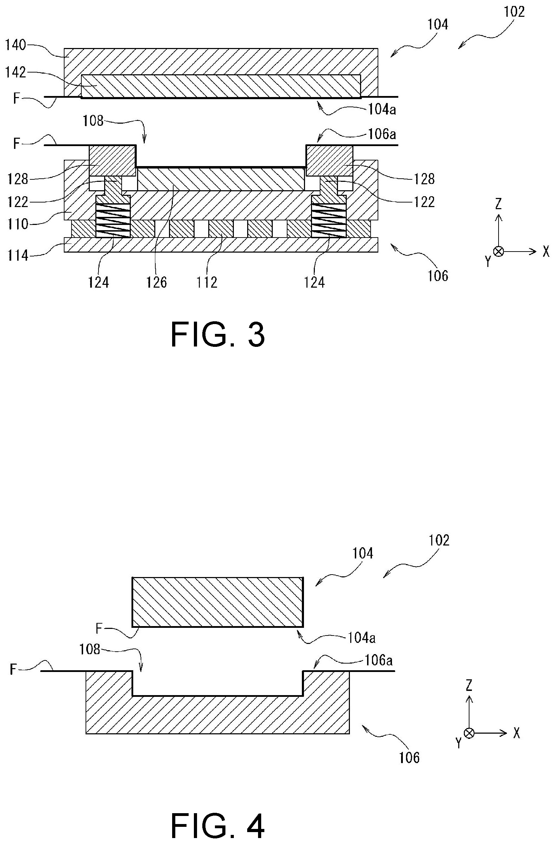

The resin forming part 50 includes a tableting mold (first mold) 102 having a pair of molds that are opened and closed (for example, multiple mold blocks made of alloy tool steel, mold plates, mold pillars, and the like, and other members assembled together). Moreover, a press apparatus (first press apparatus) 150 that drives the first mold 102 to open and close is provided. As an example, a configuration including two units of the first press apparatus 150 is adopted, but a configuration including one unit may also be adopted, or a configuration including multiple units (three or more units) may also be adopted (not shown). A side view (schematic diagram) of the first press apparatus 150 is shown in FIG. 2, and a front cross-sectional view (schematic diagram) of the first mold 102 is shown in FIG. 3.

Here, as shown in FIG. 2, the first press apparatus 150 is configured to include a pair of platens 154, 156, multiple tie bars 152 on which the pair of platens 154, 156 are installed, and a drive apparatus and the like that moves (raises and lowers) the platen 156. Specifically, the drive apparatus is configured to include a drive source (for example, an electric motor) 160, a drive transmission mechanism (for example, a ball screw or a toggle link mechanism) 162, and the like (however, the configuration is not limited thereto). In the present embodiment, the platen 154 on the upper side in the vertical direction is set as a fixed platen (a platen fixed to the tie bars 152), and the platen 156 on the lower side is set as a movable platen (a platen that is slidably held by the tie bars 152 and moves up and down). However, the configuration is not limited thereto, and the arrangement may be reversed vertically, that is, the upper side may be set as the movable platen and the lower side may be set as the fixed platen, or both the upper side and the lower side may be set as movable platens (none of which are shown).

On the other hand, as shown in FIG. 3, the first mold 102 includes a first upper mold 104 on the upper side in the vertical direction and a first lower mold 106 on the lower side, as a pair of molds arranged between the pair of platens 154, 156 in the first press apparatus 150. The first upper mold 104 is assembled to the platen on the upper side (in the present embodiment, the fixed platen 154), and the first lower mold 106 is assembled to the platen on the lower side (in the present embodiment, the movable platen 156). Mold closing and mold opening are performed by the first upper mold 104 and the first lower mold 106 approaching and separating from each other (the vertical direction (up-down direction) is the mold opening and closing direction). In the first mold 102 according to the present embodiment, the first upper mold 104 constitutes a so-called "punch mold", and the first lower mold 106 constitutes a so-called "die mold".

Next, the first lower mold 106 of the first mold 102 will be described in detail. As shown in FIG. 3, the first lower mold 106 includes a lower mold chase (first lower mold chase) 110, a cavity block (first cavity block) 126 held by the lower mold chase 110, a clamper (first clamper) 128, and the like. The first lower mold chase 110 is fixed to the upper surface of a support plate (first support plate) 114 via support pillars (first support pillars) 112. A cavity (first cavity) 108 is provided on the upper surface of the first lower mold 106 (the surface on the first upper mold 104 side). One carrier C and a predetermined amount of base resin Rm are accommodated in this first cavity 108.

The first clamper 128 is configured in an annular shape so as to surround the first cavity block 126, and is assembled to be vertically movable while being spaced apart (floating) from the upper surface of the first support plate 114 via push pins (first push pins) 122 and clamper springs (first clamper springs) 124 (for example, biasing members exemplified by coil springs) (however, the assembly structure is not limited thereto). This first cavity block 126 constitutes the inner part (bottom) of the first cavity 108, and the first clamper 128 constitutes the side part of the first cavity 108. As an example, the upper surface of the first cavity block 126 (the surface on the first upper mold 104 side) is formed in a planar shape. The shape and number of the first cavities 108 provided in one first lower mold 106 are appropriately set (one or multiple).

Here, the first press apparatus 150 is provided with a lower mold film supply part (first lower mold film supply part) 111 that supplies a film F for covering a mold surface 106a (predetermined area) including the inner surface of the first cavity 108 in the first lower mold 106. As an example, the film F is in a roll shape, but may be in a strip shape.

Moreover, the first lower mold 106 is provided with suction paths (holes, grooves, and the like) communicating with a suction apparatus at the boundary between the first clamper 128 and the first cavity block 126 and the like (not shown). This allows the film F supplied from the first lower mold film supply part 111 to be adsorbed and held on the mold surface 106a including the inner surface of the first cavity 108.

Moreover, in the present embodiment, a first lower mold heating mechanism (not shown) that heats the first lower mold 106 to a predetermined temperature is provided. This first lower mold heating mechanism includes a heater (for example, an electric heating wire heater), a temperature sensor, a power source, and the like, and heating control is performed by the control part 90. As an example, the heater is built into the first lower mold chase 110 and is configured to apply heat to the entire first lower mold 106 and the carrier C and base resin Rm accommodated in the first cavity 108. At this time, the first lower mold 106 is heated to a predetermined temperature (for example, 50°C to 80°C) at which thermosetting (full curing) of the base resin Rm is unlikely to proceed.

Next, the first upper mold 104 of the first mold 102 will be described in detail. As shown in FIG. 3, the first upper mold 104 includes a tableting plate (first plate) 142 held (fixed) to an upper mold chase (first upper mold chase) 140. This tableting plate (first plate) 142 functions to press the carrier C and a predetermined amount of base resin Rm accommodated in the first cavity 108 of the first lower mold 106 to form (tablet) a sealing resin R having a predetermined shape with the carrier C fixed thereto (details of the forming method will be described later). As an example, the lower surface of the first plate 142 (the surface on the first lower mold 106 side) is formed in a planar shape.

Here, the first press apparatus 150 is provided with an upper mold film supply part (first upper mold film supply part) 113 that supplies a film F for covering a mold surface 104a (predetermined area) of the first upper mold 104. As an example, the film F is in a roll shape, but may be in a strip shape.

Moreover, the first upper mold 104 is provided with suction paths (holes, grooves, and the like) communicating with a suction apparatus in the first plate 142 and the like (not shown). This allows the film F supplied from the first upper mold film supply part 113 to be adsorbed and held on the mold surface 104a.

Moreover, in the present embodiment, a first upper mold heating mechanism (not shown) that heats the first upper mold 104 to a predetermined temperature is provided. This first upper mold heating mechanism includes a heater (for example, an electric heating wire heater), a temperature sensor, a power source, and the like, and heating control is performed by the control part 90. As an example, the heater is built into the first upper mold chase 140 and is configured to apply heat to the entire first upper mold 104. At this time, the first upper mold 104 is heated to a predetermined temperature (for example, 50°C to 80°C) at which thermosetting (full curing) of the base resin Rm held (accommodated) in the first lower mold 106 is unlikely to proceed.

The first mold 102 described above has a structure including a movable clamper (first clamper 128) as an example, but as another example, may have a structure without a movable clamper as shown in FIG. 4.

### (Supply Unit)

Subsequently, the supply unit 10A included in the compression molding apparatus 1 will be described.

The supply unit 10A includes a supply magazine 12 in which multiple works W are stored. Here, known stack magazines, slit magazines, and the like are used for the supply magazine 12.

The supply unit 10A may be configured to include a work stage and the like (not shown) on which the work W removed from the supply magazine 12 is placed. Moreover, the supply unit 10A may be configured to include a resin stage and the like (not shown) on which the sealing resin R is placed.

The work W and the sealing resin R are held by a transport apparatus (as an example, a first loader 22) and transported to the press unit 10B, and are set at a predetermined position of the second mold 202 (details of the step will be described later). For the holding mechanism of the work W and the sealing resin R in the first loader 22, known holding mechanisms (for example, a configuration that clamps with holding claws, a configuration that adsorbs with suction holes communicating with a suction apparatus, and the like) are used (not shown).

As a modification example of the transport apparatus described above, instead of the first loader 22 that moves in the X and Y directions, a configuration may be provided separately with a transport apparatus (loader) that moves in the X direction to perform transport between units and a transport apparatus (loader) that moves in the Y direction to perform loading into and setting on the second mold 202 (not shown).

Moreover, the supply unit 10A includes a preheating heater (not shown) that performs preheating of the work W and the sealing resin R. As an example, known heating mechanisms (for example, electric heating wire heater, infrared heater, and the like) are used for the preheating heater. This allows preheating to be performed before the work W and the sealing resin R are loaded into the second mold 202. A configuration without a preheating heater may also be adopted. Moreover, instead of the preheating heater, or together with the preheating heater, a configuration may be adopted in which the first loader 22 includes a heater for preheating (not shown).

### (Press Unit)

Next, the press unit 10B included in the compression molding apparatus 1 will be described.

The press unit 10B includes a resin sealing part 70 that performs resin sealing of the work W and processing into the molded product Wp. In the present embodiment, two units (three or more units or one unit may also be adopted) of the press unit 10B including the resin sealing part 70 are provided, and one unit (two or more units may also be adopted) of the resin sealing part 70 is provided per one press unit 10B (see FIG. 1). However, the configuration is not limited thereto.

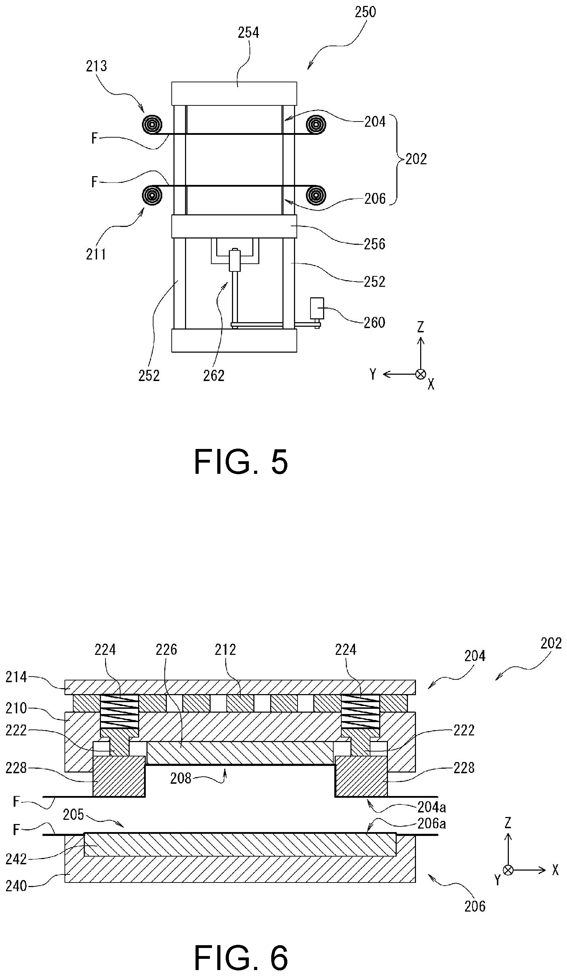

The resin sealing part 70 includes a sealing mold (second mold) 202 having a pair of molds that are opened and closed (for example, multiple mold blocks, mold plates, mold pillars, and other members made of alloy tool steel assembled together). Moreover, a press apparatus (second press apparatus) 250 that drives the second mold 202 to open and close is provided. As an example, a configuration including two units of the second press apparatus 250 is adopted, but a configuration including one unit may also be adopted, or a configuration including multiple units (three or more units) may also be adopted (not shown). A side view (schematic diagram) of the second press apparatus 250 is shown in FIG. 5, and a front cross-sectional view (schematic diagram) of the second mold 202 is shown in FIG. 6.

Here, as shown in FIG. 5, the second press apparatus 250 is configured to include a pair of platens 254, 256, multiple tie bars 252 on which the pair of platens 254, 256 are installed, and a drive apparatus that moves (raises and lowers) the platen 256. Specifically, the drive apparatus is configured to include a drive source (for example, an electric motor) 260 and a drive transmission mechanism (for example, a ball screw or toggle link mechanism) 262 (however, the configuration is not limited thereto). In the present embodiment, the upper side platen 254 in the vertical direction is set as a fixed platen (a platen fixed to the tie bars 252), and the lower side platen 256 is set as a movable platen (a platen that is slidably held by the tie bars 252 and moves up and down). However, the configuration is not limited thereto, and the arrangement may be reversed vertically, that is, the upper side may be set as a movable platen and the lower side may be set as a fixed platen, or both the upper side and the lower side may be set as movable platens (none of which are shown).

On the other hand, as shown in FIG. 6, the second mold 202 includes, as a pair of molds arranged between the pair of platens 254, 256 in the second press apparatus 250, one mold on the upper side in the vertical direction (second upper mold 204) and the other mold on the lower side (second lower mold 206). That is, the second upper mold 204 is assembled to the upper side platen (in the present embodiment, the fixed platen 254), and the second lower mold 206 is assembled to the lower side platen (in the present embodiment, the movable platen 256). Mold closing and mold opening are performed by the second upper mold 204 and the second lower mold 206 approaching and separating from each other (the vertical direction (up-down direction) becomes the mold opening and closing direction).

Next, the second upper mold 204 of the second mold 202 will be described in detail. As shown in FIG. 6, the second upper mold 204 includes an upper mold chase (second upper mold chase) 210, a cavity block (second cavity block) 226 held by the upper mold chase, a clamper (second clamper) 228, and the like. The second upper mold chase 210 is fixed to the lower surface of a support plate (second support plate) 214 via support pillars (second support pillars) 212. A cavity (second cavity) 208 is provided on the lower surface of the second upper mold 204 (the surface on the second lower mold 206 side).

The second clamper 228 is configured in an annular shape so as to surround the second cavity block 226, and is assembled to be vertically movable while being spaced apart (floating) from the lower surface of the second support plate 214 via push pins (second push pins) 222 and clamper springs (second clamper springs) 224 (for example, biasing members exemplified by coil springs) (however, the assembly structure is not limited thereto). The second cavity block 226 constitutes the inner part (bottom) of the second cavity 208, and the second clamper 228 constitutes the side part of the second cavity 208. The shape and number of the second cavities 208 provided in one second upper mold 204 are appropriately set according to the shape and number of the work W and the like (one or multiple).

Here, the second press apparatus 250 is provided with a film supply part (second upper mold film supply part) 213 that supplies a film F for covering the mold surface 204a (predetermined area) including the inner surface of the second cavity 208 in the second upper mold 204. As an example, the film F is in a roll shape, but may be in a strip shape.

Further, the second upper mold 204 is provided with suction paths (holes, grooves, and the like) communicating with a suction apparatus at the lower surface of the second clamper 228, the boundary between the second clamper 228 and the second cavity block 226, and the like (not shown). Thereby, the film F supplied from the second upper mold film supply part 213 may be adsorbed and held on the mold surface 204a including the inner surface of the second cavity 208.

Further, in the present embodiment, a second upper mold heating mechanism (not shown) that heats the second upper mold 204 to a predetermined temperature is provided. This second upper mold heating mechanism includes a heater (for example, an electric heating wire heater), a temperature sensor, a power source, and the like, and heating control is performed by the control part 90. As an example, the heater is built into the second upper mold chase 210 and heats the second upper mold 204 to a predetermined temperature (for example, 100°C to 300°C).

Next, the second lower mold 206 of the second mold 202 will be described in detail. As shown in FIG. 6, the second lower mold 206 includes a lower mold chase (second lower mold chase) 240, a lower plate (second plate) 242 held by the lower mold chase and the like.

Further, the second lower mold 206 is provided with a work holding part 205 that holds (including placing) the sealing resin R and the work W at a predetermined position on the upper surface of the second plate 242. In the present embodiment, the work W is held by the work holding part 205 in a state of being sandwiched between two sealing resins R arranged such that the respective carriers C are on the outer side (so as not to face each other). A known suction apparatus, chuck claws, and the like may be used for the holding mechanism.

Here, the second press apparatus 250 is provided with a film supply part (second lower mold film supply part) 211 that supplies a film F for covering the mold surface 206a (predetermined area) of the second lower mold 206. As an example, the film F is in a roll shape, but may be in a strip shape.

Further, the second lower mold 206 is provided with suction paths (holes, grooves, and the like) communicating with a suction apparatus in the lower plate (second plate) 242 and the like (not shown). Thereby, the film F supplied from the second lower mold film supply part 211 may be adsorbed and held on the mold surface 206a.

Further, in the present embodiment, a second lower mold heating mechanism (not shown) that heats the second lower mold 206 to a predetermined temperature is provided. This second lower mold heating mechanism includes a heater (for example, an electric heating wire heater), a temperature sensor, a power source, and the like, and heating control is performed by the control part 90. As an example, the heater is built into the second lower mold chase 240 and heats the second lower mold 206 to a predetermined temperature (for example, 100°C to 300°C).

### (Storage Unit)

Next, the storage unit 10C included in the compression molding apparatus 1 will be described.

The molded product Wp is held by a transport apparatus (as an example, a second loader 24), unloaded from the second mold 202, and transported to the storage unit 10C. For the holding mechanism of the molded product Wp in the second loader 24, a known holding mechanism (for example, a configuration that clamps with holding claws, a configuration that adsorbs with suction holes communicating with a suction apparatus, and the like) is used (not shown).

As a modification example of the transport apparatus, instead of the second loader 24 that moves in the X and Y directions, a configuration may be adopted in which a transport apparatus (loader) that moves in the X direction and performs transport between units and a transport apparatus (loader) that moves in the Y direction and performs unloading from the second mold 202 are separately provided (not shown).

The storage unit 10C may be configured to include a molded product stage and the like (not shown) on which the molded product Wp transported from the press unit 10B is placed.

Next, the storage unit 10C includes, as an example, a carrier peeling apparatus 16 that peels the carrier C from the molded product Wp. A configuration including a reversing mechanism that reverses the molded product Wp such that the upper and lower surfaces are reversed may be adopted as needed (not shown). For the carrier peeling apparatus 16, a mechanism that adsorbs and peels the carrier C and the like may be used.

Moreover, the storage unit 10C includes, as an example, a cutting apparatus 18 that cuts a predetermined position of the molded product Wp. Specifically, the cutting apparatus 18 performs an operation of cutting in the thickness direction within the area of the molded product Wp where the carrier C has been peeled, and removing the outer edge. For the cutting apparatus 18, a known mechanical cutter or thermal melting cutter may be used.

Moreover, the storage unit 10C includes a storage magazine 14 that stores the molded product Wp after the carrier C has been peeled and the predetermined position has been cut. For the relevant storage magazine 14, a known stack magazine and the like may be used. The carrier peeling apparatus 16 and the cutting apparatus 18 may be provided separately without being attached to this apparatus, and in that case, a configuration may be adopted in which the molded product Wp in a state where peeling or cutting has not been performed is stored.

The carrier C peeled from the molded product Wp is held by a transport apparatus (as an example, the second loader 24) and transported from the storage unit 10C to the resin forming unit 10E (or the base resin supply unit 10D). A configuration in which the carrier C is transported by a transport apparatus other than the second loader 24 (not shown) may also be adopted. According to this configuration, the peeled carrier C may be reused when forming the sealing resin R.

### (Compression Molding Method)

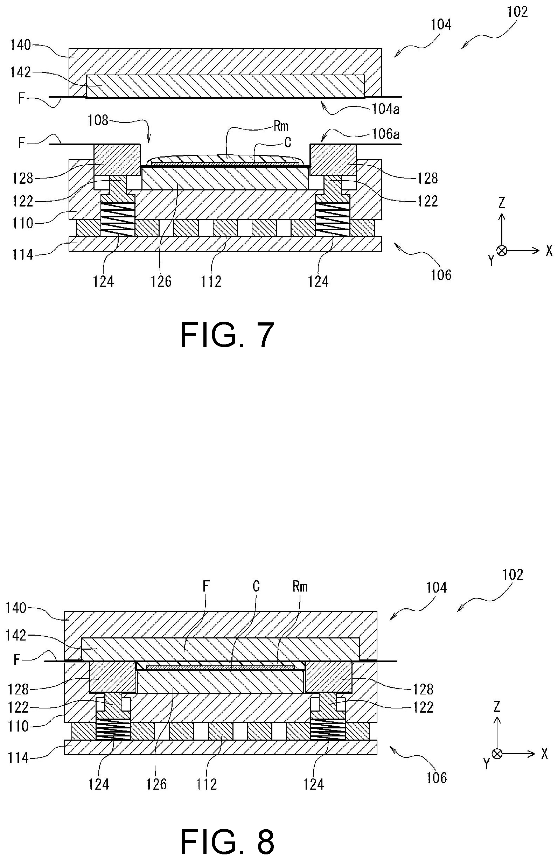

Next, the steps of the compression molding method according to the present embodiment performed using the compression molding apparatus 1 described above will be described. Here, FIG. 7 to FIG. 13 are explanatory diagrams of each step, and are illustrated as front cross-sectional views in the same direction as FIG. 3 and FIG. 6.

First, a first preparation step is performed. The first preparation step includes the following steps. A heating step (first lower mold heating step) is performed in which the first lower mold 106 is adjusted to a predetermined temperature (a temperature at which the base resin Rm and the sealing resin R do not fully cure, for example, 50°C to 80°C) and heated by the first lower mold heating mechanism. Moreover, a heating step (first upper mold heating step) is performed in which the first upper mold 104 is adjusted to a predetermined temperature (a temperature at which the base resin Rm and the sealing resin R do not fully cure, for example, 50°C to 80°C) and heated by the first upper mold heating mechanism. Moreover, a lower mold film supply step (first lower mold film supply step) is performed in which the first lower mold film supply part 111 is operated to supply a new film F and cause it to be adsorbed so as to cover a predetermined area of the mold surface 106a including the inner surface of the first cavity 108 in the first lower mold 106. Moreover, an upper mold film supply step (first upper mold film supply step) is performed in which the first upper mold film supply part 113 is operated to supply a new film F and cause it to be adsorbed so as to cover a predetermined area of the mold surface 104a of the first upper mold 104.

Before or after the first preparation step described above, or in parallel therewith, a resin preparation step is performed in which the base resin Rm in a state where the carrier C is fixed thereto is prepared as the sealing resin R.

As an example of the resin preparation step, the carrier C is supplied in the carrier supply part 30. Moreover, in the base resin supply part 40, a predetermined amount of base resin Rm is supplied by a dispenser or the like (not shown). Next, in the resin forming part 50, a tableting step is performed in which the carrier C and the base resin Rm are tableted to form the sealing resin R in a solid state formed into a predetermined shape with the carrier C fixed thereto. Note that "solid" includes those that have melted to a so-called B-stage or are in such a state, since tableting is performed while heating to a temperature at which curing is difficult to progress. As an example, the carrier C was placed in the lower mold 106 before supplying the base resin Rm, but the carrier C may also be attached to the lower side of the film F of the upper mold 104.

Specifically, in the tableting step described above, the carrier C supplied from the carrier supply part 30 is transported by a transport apparatus (for example, the first loader 22 or the like) and accommodated at a predetermined position (for example, a central position) within the first cavity 108 of the first lower mold 106. Next, a predetermined amount of base resin Rm supplied from the base resin supply part 40 is transported by a transport apparatus (for example, the first loader 22 or the like), or directly spread from a dispenser or the like, and accommodated within the first cavity 108 of the first lower mold 106. As an example, within the first cavity 108, the base resin Rm is placed on top of the carrier C that was previously accommodated (see FIG. 7). Next, the first press apparatus 150 is operated to perform Mold closing of the first mold 102 that has been heated to the predetermined temperature described above (see FIG. 8). At this time, the first cavity block 126 relatively rises within the first cavity 108, and the carrier C and the base resin Rm are tableted (sandwiched and pressurized) by the first cavity block 126 and the first plate 142. As a result, the sealing resin R in a solid state having a predetermined shape with the carrier C fixed thereto and not thermosetting (not fully cured) is formed.

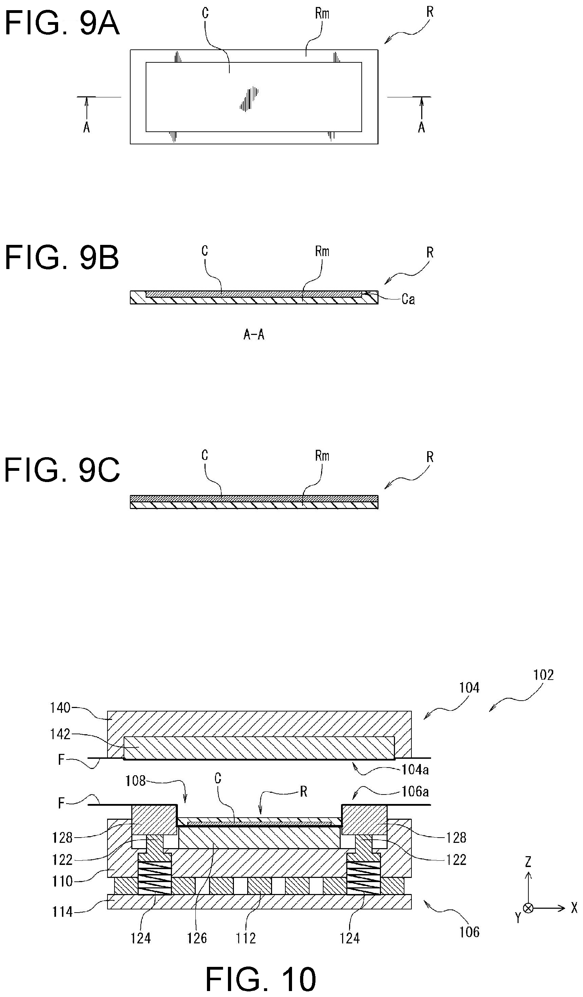

As an example, the "predetermined shape" described above is, as shown in FIG. 9A (a plan view with the exposed surface of the carrier C as the upper surface) and FIG. 9B (a cross-sectional view taken along line A-A in FIG. 9A), a shape in which the carrier C is arranged at the central part in plan view, and the base resin Rm (in a solid state after tableting) is arranged at the peripheral part so as to cover the outer periphery Ca of the carrier C. According to this, since the adhesion between the carrier C and the base resin Rm can be enhanced, unintended mutual peeling can be prevented from occurring. Note that it is not necessarily required for the end portions of the base resin Rm to extend further outward to the outside, and as shown in FIG. 9C (a cross-sectional view similar to FIG. 9B), the carrier C and the base resin Rm may be substantially the same. Moreover, a base resin Rm having a recess formed therein may be prepared, and the carrier C may be adhered to the recess. Furthermore, a flat plate-shaped carrier C may be adhered to a simple flat plate-shaped base resin Rm without a recess. The fixing described above includes adhesion.

It is important that the tableting step described above is performed at a temperature at which thermosetting (full curing) of the base resin Rm is unlikely to proceed (performed by heating the first lower mold 106 and the first upper mold 104 to a temperature at which thermosetting (full curing) is unlikely to proceed), such that the sealing resin R to be formed may be thermoset (fully cured) in the subsequent resin sealing step. As described above, the "temperature at which thermosetting is unlikely to proceed" depends on the material of the base resin Rm, but as a specific example, is approximately 50°C to 80°C (in the present embodiment, approximately 70°C).

Moreover, it is preferable that powder resin is used as the base resin Rm. According to this, compared to cases where granular resin or crushed resin is used, the resin amount may be adjusted and supplied extremely accurately. However, the resin is not limited to powder resin.

Moreover, as another example of the resin preparation step, the sealing resin R having the same configuration as described above may be configured to be formed in advance outside the apparatus and supplied to the present apparatus (compression molding apparatus 1) by being stored in a stocker or the like, or by a transport apparatus (not shown).

After the tableting step, a mold opening step (first mold opening step) is performed in which the first mold 102 is opened, and the sealing resin R (in a state where the carrier C is fixed to the lower surface side) and the used film F are separated such that the sealing resin R may be removed (see FIG. 10). In the present embodiment, by including the lower mold film supply step and the upper mold film supply step described above, the film F is arranged on both the mold surface 106a of the first lower mold 106 and the mold surface 104a of the first upper mold 104, such that release of the sealing resin R formed by tableting becomes easy, and defects due to resin adhesion to the mold can be prevented.

Moreover, after the first mold opening step, or in parallel therewith, a film supply step (first lower mold film supply step, first upper mold film supply step) is performed in which the first lower mold film supply part 111 and the first upper mold film supply part 113 are operated to send out the used film F from inside the first mold 102, and to send in and set new film F into the first mold 102.

Moreover, before or after, or in parallel with the first preparation step described above, a second preparation step is performed. The second preparation step includes the following steps. A heating step (second upper mold heating step) is performed in which the second upper mold 204 is adjusted to a predetermined temperature (for example, 100°C to 300°C) and heated by the second upper mold heating mechanism. Moreover, a heating step (second lower mold heating step) is performed in which the second lower mold 206 is adjusted to a predetermined temperature (for example, 100°C to 300°C) and heated by the second lower mold heating mechanism. Moreover, a lower mold film supply step (second lower mold film supply step) is performed in which the second lower mold film supply part 211 is operated to supply new film F and cause it to be adsorbed so as to cover a predetermined area of the mold surface 106a of the second lower mold 206. Moreover, an upper mold film supply step (second upper mold film supply step) is performed in which the second upper mold film supply part 213 is operated to supply new film F and cause it to be adsorbed so as to cover a predetermined area of the mold surface 204a of the second upper mold 204 including the inner surface of the second cavity 208.

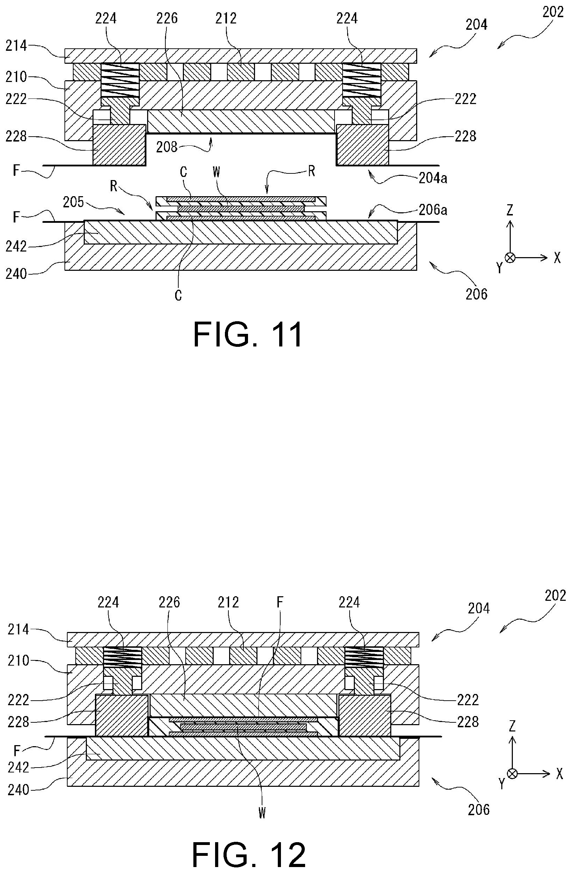

After the second preparation step, a setting step is performed in which the sealing resin R and the work W are set inside the sealing mold (second mold 202). As shown in FIG. 11, the work W is held (including placed) on the work holding part 205 in a state of being sandwiched between two sealing resins R arranged such that the respective carriers C are on the outer sides.

As an example of the setting step described above, the first sealing resin R prepared in the resin preparation step is transported by a transport apparatus (for example, the first loader 22 or the like), and placed on the work holding part 205 with the surface where the carrier C is exposed facing downward. Next, the work W supplied from the supply magazine 12 is transported by a transport apparatus (for example, the first loader 22 or the like), and placed on the first sealing resin R. Next, the second sealing resin R prepared in the resin preparation step is transported by a transport apparatus (for example, the first loader 22 or the like), and placed on the work W with the surface where the carrier C is exposed facing upward.

Alternatively, as another example of the setting step, the first sealing resin R and the second sealing resin R prepared in the resin preparation step, and the work W supplied from the supply magazine 12 are stacked such that the work W is sandwiched between the two (first and second) sealing resins R arranged such that the respective carriers C are on the outer sides (that is, the first sealing resin R is prepared with the surface where the carrier C is exposed facing downward, the work W is placed on the first sealing resin R, and the second sealing resin R is placed on the work W with the surface where the carrier C is exposed facing upward). Next, the first sealing resin R, the work W, and the second sealing resin R in the stacked state are transported by a transport apparatus (for example, the first loader 22 or the like), and placed on the work holding part 205. In this case, there is an advantage that the transport of the work W and the two sealing resins R to the second mold 202 is performed at one time rather than separately.

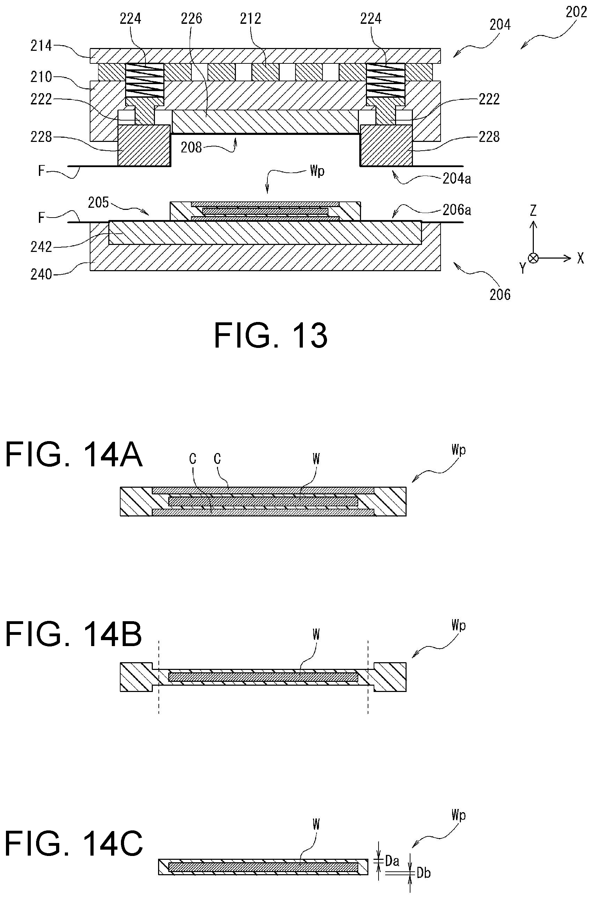

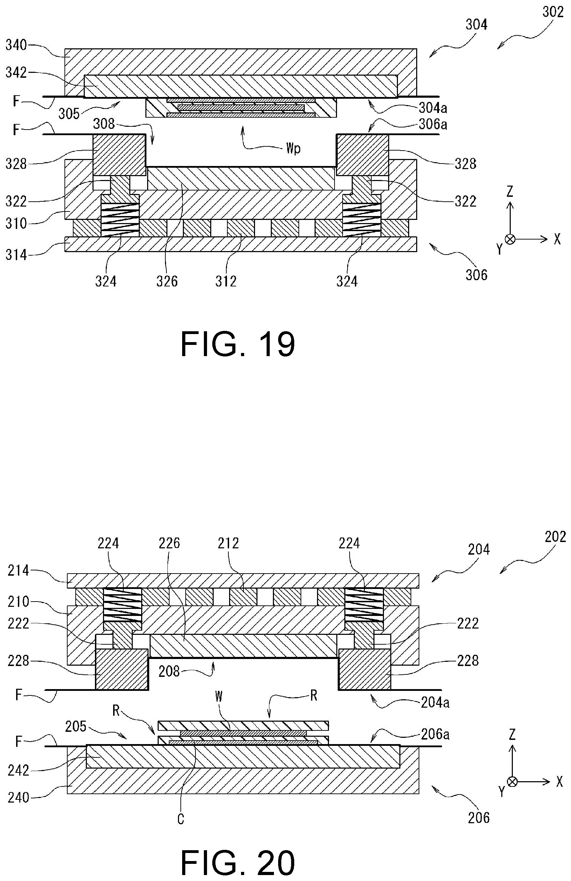

After performing all of the above steps, a resin sealing step is performed in which the work W is sealed with the sealing resin R (in the present embodiment, in a state sandwiched between two sealing resins R) and processed into a molded product Wp. Specifically, Mold closing of the second mold 202 is performed, the second cavity block 226 is relatively lowered within the second cavity 208, and a mold closing step (second mold closing step) is performed in which the sealing resin R is heated and pressurized against the work W. As a result, the sealing resin R is thermally cured and resin sealing (compression molding) is completed (see FIG. 12). As a result, a molded product Wp having the shape shown in FIG. 14A is formed. In the present embodiment, as shown in FIG. 11, the work W is sandwiched from above and below by the sealing resin R with the carrier C and compression molded vertically, but as another example, as shown in FIG. 20, the sealing resin R with the carrier C may be on only one of the upper and lower sides, and the other may be the sealing resin R without the carrier C.

After the second mold closing step, a mold opening step (second mold opening step) is performed in which mold opening of the second mold 202 is performed, and the molded product Wp and the used film F are separated such that the molded product Wp may be removed (see FIG. 13). Next, a molded product unloading step is performed in which the molded product Wp is unloaded from within the second mold 202 by a transport apparatus (for example, the second loader 24 or the like) and transported to the storage unit 10C.

After the molded product unloading step, or in parallel therewith, a film supply step (second lower mold film supply step, second upper mold film supply step) is performed in which the second lower mold film supply part 211 and the second upper mold film supply part 213 are operated to send out the used film F from within the second mold 202 and send in and set a new film F into the second mold 202.

Further, after the molded product unloading step, a carrier peeling step is performed in which the carrier C is peeled from the molded product Wp using the carrier peeling apparatus 16. As a result, a molded product Wp having the shape shown in FIG. 14B is formed. In this step, the molded product Wp may be inverted midway through, and the carriers C on the upper surface and lower surface may be peeled sequentially by one peeling mechanism, or alternatively, without inverting the molded product Wp, the carriers C on the upper surface and lower surface may be peeled respectively by two peeling mechanisms.

After the carrier peeling step, a step is performed in which the carrier C peeled from the molded product Wp is transported from the storage unit 10C to the resin forming unit 10E (or the base resin supply unit 10D) by a transport apparatus (for example, the second loader 24 or the like) (it is sufficient to ultimately return the carrier C to the resin forming part 50). When the carrier C is used as a heat dissipation plate or the like in the final product, it is not necessarily required to peel the carrier C.

According to the above configuration, the carrier C may be reused from the resin preparation step in which the carrier C is peeled from the molded product Wp and the sealing resin R (that is, the base resin Rm in a state where the carrier C is fixed) is prepared (formed). Therefore, reduction of manufacturing cost can be achieved by reducing the number of parts (the total number of required carriers C). Further, since it is not required to prepare many carriers C in advance, miniaturization of the apparatus can be achieved mainly in terms of the size and installation space of the storage part for the carriers C (for example, a stocker or the like).

Further, after the carrier peeling step, a cutting step is performed in which a predetermined position of the molded product Wp (the dashed line position shown in FIG. 14B) is cut. Specifically, using the cutting apparatus 18, the area where the carrier C has been peeled in the molded product Wp is cut in the thickness direction to remove the outer edge. As a result, a molded product Wp (final target shape) having the shape shown in FIG. 14C, that is, having a thin resin thickness (resin thickness of the upper or lower portion of the work W), may be formed.

After the cutting step, a storage step is performed in which the molded product Wp (in the present embodiment, in a state where the carrier C has been peeled and the predetermined position has been cut) is stored in the storage magazine 14. It is also possible to perform a step of storing the molded product Wp without performing the carrier peeling step or the cutting step (that is, in a state where peeling or cutting has not been performed).

The above are the main steps of the compression molding method performed using the compression molding apparatus 1. However, the above step order is an example, and changing the order or performing processes in parallel is possible as long as there is no problem.

As described above, when attempting to form a molded product Wp that is thin to the extent that the resin thickness after resin sealing (specifically, as shown in FIG. 14C, the thickness Da of the resin portion at the upper position of the work W after resin sealing or the thickness Db of the resin portion at the lower position) becomes 0.4 mm or less, the thickness of the sealing resin (solid resin) before resin sealing is also required to be made thin. However, since the sealing resin (solid resin) before resin sealing is naturally in a state before full curing, it has low rigidity (is brittle) and weak strength, and therefore there was a problem that breakage is extremely likely to occur during handling (particularly during transport). In particular, it was also confirmed that this is more pronounced in the case of sealing resin (solid resin) formed by tableting. In contrast, according to the compression molding apparatus 1 and the compression molding method using the sealing resin R according to the present embodiment, the above problem can be solved, that is, breakage during handling (particularly during transport) of the sealing resin R can be prevented, and a molded product Wp having a thin resin portion thickness may be formed. It has been verified through experiments by the present inventor that a shape with Da=Db=0.1 mm can also be achieved.

Further, by using the sealing resin R having the above configuration, it is possible to solve or reduce problems such as uneven spreading, residual gas, and dust generation during molding caused by granular resin, as well as the problem of difficult handling, as in conventional methods.

### [Second Embodiment]

Next, a second embodiment of the invention will be described. The compression molding apparatus 1 and the compression molding method according to the present embodiment have the same basic configuration as the first embodiment described above, but have differences in the configuration of the press unit 10B (particularly, the configuration of the press apparatus and the sealing mold), as well as in the steps performed mainly in the press unit 10B. Hereinafter, the present embodiment will be described focusing on the differences.

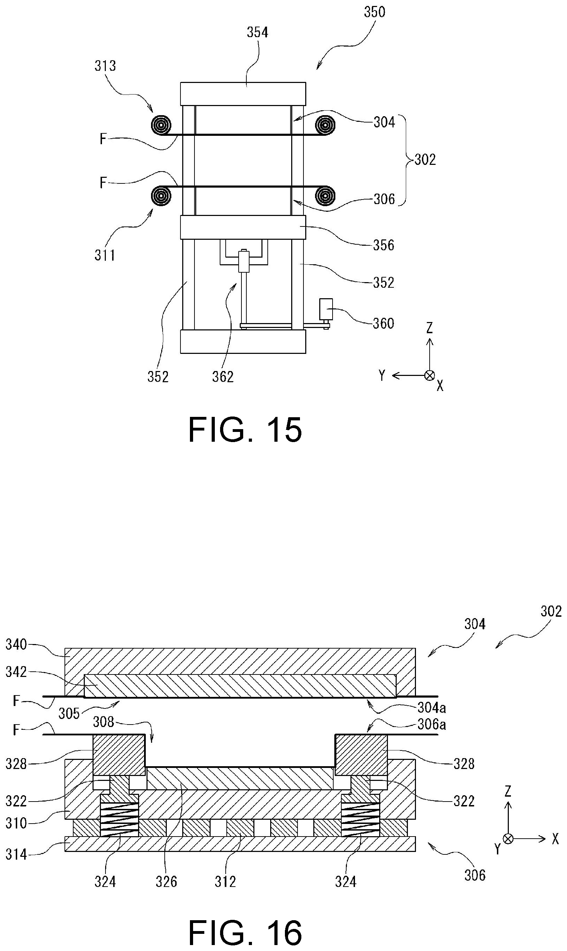

The press unit 10B according to the present embodiment includes a sealing mold (third mold) 302 having a pair of molds that are opened and closed (for example, multiple mold blocks, mold plates, mold pillars, and other members made of alloy tool steel assembled together). Further, a press apparatus (third press apparatus) 350 that drives the third mold 302 to open and close is provided. As an example, in FIG. 1 (illustrated as a configuration common to the second press apparatus 250), a configuration including two third press apparatuses 350 is shown, but a configuration including one unit may be used, or a configuration including multiple units (three or more units) may be used (not shown). A side view (schematic diagram) of the third press apparatus 350 is shown in FIG. 15, and a front cross-sectional view (schematic diagram) of the third mold 302 is shown in FIG. 16.

Here, as shown in FIG. 15, the third press apparatus 350 is configured to include a pair of platens 354, 356, multiple tie bars 352 on which the pair of platens 354, 356 are installed, and a drive apparatus that moves (raises and lowers) the platen 356. Specifically, the drive apparatus is configured to include a drive source (for example, an electric motor) 360 and a drive transmission mechanism (for example, a ball screw or toggle link mechanism) 362 (however, the configuration is not limited thereto). In the present embodiment, the upper platen 354 in the vertical direction is set as a fixed platen (a platen fixed to the tie bars 352), and the lower platen 356 is set as a movable platen (a platen that is slidably held by the tie bars 352 and moves up and down). However, the configuration is not limited thereto, and the arrangement may be reversed, that is, the upper side may be set as a movable platen and the lower side may be set as a fixed platen, or both the upper side and the lower side may be set as movable platens (none of which are shown).

On the other hand, as shown in FIG. 16, the third mold 302 includes, as a pair of molds arranged between the pair of platens 354, 356 in the third press apparatus 350, one mold on the upper side in the vertical direction (third upper mold 304) and the other mold on the lower side (third lower mold 306). That is, the third upper mold 304 is assembled to the upper platen (in the present embodiment, the fixed platen 354), and the third lower mold 306 is assembled to the lower platen (in the present embodiment, the movable platen 356). Mold closing and mold opening are performed by the third upper mold 304 and the third lower mold 306 approaching and separating from each other (the vertical direction (up-down direction) is the mold opening and closing direction).

Next, the third lower mold 306 of the third mold 302 will be described in detail. As shown in FIG. 16, the third lower mold 306 includes a lower mold chase (third lower mold chase) 310, a cavity block (third cavity block) 326 held by the lower mold chase, a clamper (third clamper) 328, and the like. The third lower mold chase 310 is fixed to the upper surface of a support plate (third support plate) 314 via support pillars (third support pillars) 312. A cavity (third cavity) 308 is provided on the upper surface of the third lower mold 306 (the surface on the third upper mold 304 side).

The third clamper 328 is configured in an annular shape so as to surround the third cavity block 326, and is assembled to be vertically movable while being spaced apart (floating) from the upper surface of the third support plate 314 via push pins (third push pins) 322 and clamper springs (third clamper springs) 324 (for example, biasing members exemplified by coil springs) (however, the assembly structure is not limited thereto). The third cavity block 326 constitutes the inner part (bottom) of the third cavity 308, and the third clamper 328 constitutes the side part of the third cavity 308. The shape and number of the third cavities 308 provided in one third lower mold 306 are appropriately set according to the shape and number of the works W and the like (one or multiple).

Here, the third press apparatus 350 is provided with a film supply part (third lower mold film supply part) 311 that supplies a film F for covering the mold surface 306a (predetermined area) including the inner surface of the third cavity 308 in the third lower mold 306. As an example, the film F is in a roll shape, but may be in a strip shape.

Further, the third lower mold 306 is provided with suction paths (holes, grooves, and the like) communicating with a suction apparatus on the upper surface of the third clamper 328, at the boundary between the third clamper 328 and the third cavity block 326, and the like (not shown). Thereby, the film F supplied from the third lower mold film supply part 311 may be adsorbed and held on the mold surface 306a including the inner surface of the third cavity 308.

Further, in the present embodiment, a third lower mold heating mechanism (not shown) that heats the third lower mold 306 to a predetermined temperature is provided. This third lower mold heating mechanism includes a heater (for example, an electric heating wire heater), a temperature sensor, a power source, and the like, and heating control is performed by the control part 90. As an example, the heater is built into the third lower mold chase 310 and heats the third lower mold 306 to a predetermined temperature (for example, 100°C to 300°C).

Next, the third upper mold 304 of the third mold 302 will be described in detail. As shown in FIG. 16, the third upper mold 304 includes an upper mold chase (third upper mold chase) 340, an upper plate (third plate) 342 held by the upper mold chase and the like.

Further, in the present embodiment, a holding part 305 is provided that holds the molded product Wp after resin sealing at a predetermined position on the lower surface of the third plate 342. As an example, this holding part 305 is arranged penetrating through the third plate 342 and has a suction path (holes, grooves, and the like) communicating with a suction apparatus (not shown). Specifically, one end of the suction path communicates with the mold surface 304a of the third upper mold 304, and the other end is connected to a suction apparatus arranged outside the third upper mold 304. Thereby, it becomes possible to drive the suction apparatus to perform suction from the suction path and adsorb and hold the molded product Wp after resin sealing on the mold surface 304a (here, the lower surface of the third plate 342). Instead of the above adsorption holding mechanism, or together with the adsorption holding mechanism, a configuration including holding claws that clamp the outer periphery of the molded product Wp may be adopted (not shown). The shape and number of the holding parts 305 provided in one third upper mold 304 are appropriately set (one or multiple).

Here, the third press apparatus 350 is provided with an upper mold film supply part (third upper mold film supply part) 313 that supplies a film F for covering the mold surface 304a (predetermined area) of the third upper mold 304. As an example, the film F is in a roll shape, but may be in a strip shape.

Further, the third upper mold 304 is provided with suction paths (holes, grooves, and the like) communicating with a suction apparatus in the third plate 342 and the like (not shown). Thereby, the film F supplied from the third upper mold film supply part 313 may be adsorbed and held on the mold surface 304a.

Further, in the present embodiment, a third upper mold heating mechanism (not shown) that heats the third upper mold 304 to a predetermined temperature is provided. This third upper mold heating mechanism includes a heater (for example, an electric heating wire heater), a temperature sensor, a power source, and the like, and heating control is performed by the control part 90. As an example, the heater is built into the third upper mold chase 340 and heats the third upper mold 304 to a predetermined temperature (for example, 100°C to 300°C).

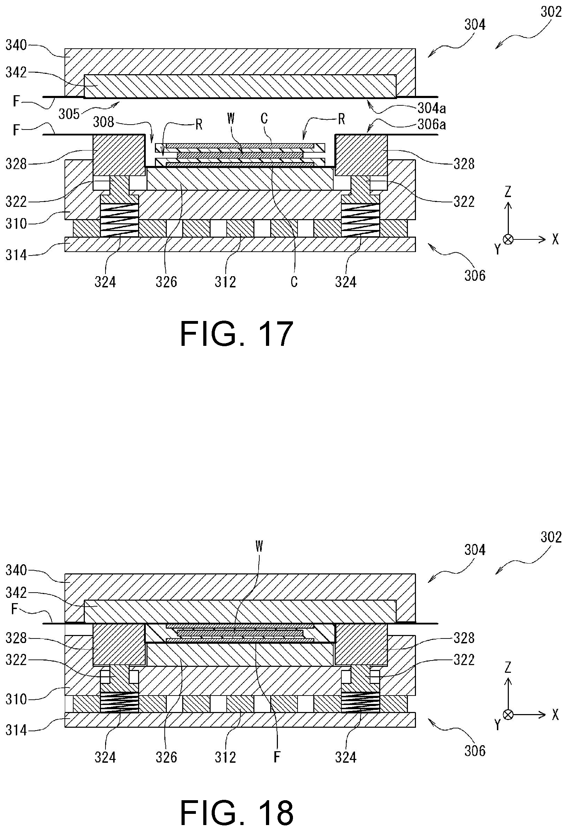

Next, the steps of the compression molding method according to the present embodiment performed using the compression molding apparatus 1 having the above configuration will be described. Here, FIG. 17 to FIG. 19 are explanatory diagrams of each step, and are illustrated as front cross-sectional views in the same direction as FIG. 16.

First, a first preparation step is performed. Specifically, this is the same as in the first embodiment.

Before or after the above first preparation step, or in parallel therewith, a resin preparation step is performed to prepare the base resin Rm in a state where the carrier C is fixed thereto as the sealing resin R. The specific step is the same as in the first embodiment.

Further, in the present embodiment, a third preparation step is performed instead of the aforementioned second preparation step. The third preparation step includes the following steps. A heating step (third upper mold heating step) is performed in which the third upper mold 304 is adjusted and heated to a predetermined temperature (for example, 100°C to 300°C) by the third upper mold heating mechanism. Further, a heating step (third lower mold heating step) is performed in which the third lower mold 306 is adjusted and heated to a predetermined temperature (for example, 100°C to 300°C) by the third lower mold heating mechanism. Further, a lower mold film supply step (third lower mold film supply step) is performed in which the third lower mold film supply part 311 is operated to supply a new film F and adsorb it so as to cover a predetermined area of the mold surface 306a including the inner surface of the third cavity 308 in the third lower mold 306. Further, an upper mold film supply step (third upper mold film supply step) is performed in which the third upper mold film supply part 313 is operated to supply a new film F and adsorb it so as to cover a predetermined area of the mold surface 304a of the third upper mold 304.

After the third preparation step, a setting step is performed to set the sealing resin R and the work W in the sealing mold (third mold 302). As shown in FIG. 17, the work W is held (including placed) in the third cavity 308 (on the third cavity block 326) in a state of being sandwiched between two sealing resins R arranged such that the respective carriers C are on the outer sides.

As an example of the above setting step, the first sealing resin R prepared in the resin preparation step is transported by a transport apparatus (for example, the first loader 22 or the like), and placed in the third cavity 308 (on the third cavity block 326) with the surface where the carrier C is exposed facing downward. Next, the work W supplied from the supply magazine 12 is transported by a transport apparatus (for example, the first loader 22 or the like), and placed on the first sealing resin R. Next, the second sealing resin R prepared in the resin preparation step is transported by a transport apparatus (for example, the first loader 22 or the like), and placed on the work W with the surface where the carrier C is exposed facing upward.

Alternatively, as another example of the setting step, the first sealing resin R and the second sealing resin R prepared in the resin preparation step, and the work W supplied from the supply magazine 12 are stacked such that the work W is sandwiched between the two (first and second) sealing resins R arranged such that the respective carriers C are on the outer sides (that is, the first sealing resin R is prepared with the surface where the carrier C is exposed facing downward, the work W is placed on the first sealing resin R, and the second sealing resin R is placed on the work W with the surface where the carrier C is exposed facing upward). Next, the first sealing resin R, the work W, and the second sealing resin R in the stacked state are transported by a transport apparatus (for example, the first loader 22 or the like), and placed in the third cavity 308 (on the third cavity block 326). In this case, there is an advantage that the transport of the work W and the two sealing resins R to the third mold 302 is performed at once rather than separately.

After performing all of the above steps, a resin sealing step is performed in which the work W is sealed with the sealing resin R (in the present embodiment, in a state sandwiched between two sealing resins R) and processed into a molded product Wp. Specifically, a mold closing step (third mold closing step) is performed in which the third mold 302 is closed, the third cavity block 326 is relatively raised in the third cavity 308, and the sealing resin R is heated and pressurized against the work W. As a result, the sealing resin R is thermoset and the resin sealing (compression molding) is completed (see FIG. 18). The configuration of the molded product Wp is the same as that in FIG. 14A.

After the third mold closing step, a mold opening step (third mold opening step) is performed in which the third mold 302 is opened, and the molded product Wp and the used film F are separated such that the molded product Wp may be removed (see FIG. 19). Next, a molded product unloading step is performed in which the molded product Wp is unloaded from inside the third mold 302 by a transport apparatus (for example, the second loader 24 or the like) and transported to the storage unit 10C.

After the molded product unloading step, or in parallel therewith, a film supply step (third lower mold film supply step, third upper mold film supply step) is performed in which the third lower mold film supply part 311 and the third upper mold film supply part 313 are operated to send out the used film F from inside the third mold 302, and a new film F is sent into the third mold 302 and set.

Moreover, after the molded product unloading step, a carrier peeling step is performed (the configuration of the molded product Wp is the same as that in FIG. 14B). Moreover, after the carrier peeling step, a cutting step is performed (the configuration of the molded product Wp is the same as that in FIG. 14C). Moreover, after the cutting step, a storage step is performed. In each case, the specifics are the same as in the first embodiment. The carrier peeling step or the cutting step may also be omitted.

Other configurations according to the present embodiment are the same as those of the first embodiment described above, and repeated description is omitted.

According to the above second embodiment, the same effects as those of the first embodiment described above can be obtained.

As described above, according to the invention, it is possible to prevent the occurrence of molding defects caused by uneven spreading of the sealing resin, residual gas, and dust generation during molding. Moreover, handling of the sealing resin can be facilitated, and even in the case of forming a thin molded product in which the thickness of the resin portion is 0.4 mm or less in particular, it is possible to prevent the occurrence of breakage of the sealing resin during handling. Moreover, by applying to a configuration in which a cavity is provided in the upper mold and the work is held in the lower mold, problems such as the work falling can be resolved.

Furthermore, since the carrier may be peeled from the molded product and reused from the resin preparation step for preparing (forming) the sealing resin, it is possible to reduce manufacturing cost by reducing the number of parts, and to achieve miniaturization of the apparatus mainly including the carrier storage part.

The invention is not limited to the above embodiments, and various modifications are possible without departing from the invention.

## Claims

1. A compression molding apparatus, sealing a work with a sealing resin and processing it into a molded product using a sealing mold comprising an upper mold and a lower mold,
wherein as the sealing resin, a base resin in a state where a carrier is fixed thereto is used, and
the compression molding apparatus comprises a carrier peeling apparatus that peels the carrier from the molded product.

2. A compression molding apparatus, sealing a work with a sealing resin and processing it into a molded product using a sealing mold comprising an upper mold and a lower mold,
wherein as the sealing resin, a base resin in a state where a carrier is fixed thereto is used, and
the carrier constitutes a heat dissipation plate in the molded product.

3. The compression molding apparatus according to claim 1 or claim 2,
wherein as the sealing resin, a solid resin formed into a predetermined shape with the carrier fixed thereto by tableting powder resin is used.

4. The compression molding apparatus according to claim 1, comprising:
a transport apparatus that performs transport for returning the carrier peeled from the molded product to an apparatus that performs forming of the sealing resin.

5. The compression molding apparatus according to claim 1, comprising:
a cutting apparatus that cuts, in a thickness direction, within an area of the molded product where the carrier has been peeled, to remove an outer edge.

6. A compression molding method, sealing a work with a sealing resin and processing it into a molded product using a sealing mold comprising an upper mold and a lower mold, the compression molding method comprising:
a resin preparation step of preparing, as the sealing resin, a base resin in a state where a carrier is fixed thereto;
a transport step of transporting the sealing resin into the sealing mold;
a resin sealing step of sealing the work with the sealing resin and processing it into the molded product by performing mold closing of the sealing mold; and
a carrier peeling step of peeling the carrier from the molded product.

7. A compression molding method, sealing a work with a sealing resin and processing it into a molded product using a sealing mold comprising an upper mold and a lower mold, the compression molding method comprising:
a resin preparation step of preparing, as the sealing resin, a base resin in a state where a carrier is fixed thereto;
a transport step of transporting the sealing resin into the sealing mold; and
a resin sealing step of sealing the work with the sealing resin and processing it into the molded product by performing mold closing of the sealing mold,
wherein the carrier constitutes a heat dissipation plate in the molded product.

8. The compression molding method according to claim 6 or claim 7,
wherein the resin preparation step comprises a step of forming the sealing resin within a compression molding apparatus, or a step of forming the sealing resin outside a compression molding apparatus and supplying it into the compression molding apparatus.

9. The compression molding method according to claim 6 or claim 7,
wherein as the sealing resin, a solid resin formed into a predetermined shape with the carrier fixed thereto by tableting powder resin is used.

10. The compression molding method according to claim 6, further comprising:
a step of returning the carrier peeled from the molded product to an apparatus that performs forming of the sealing resin and reusing it when performing forming of the sealing resin.

11. The compression molding method according to claim 6, further comprising:
a step of cutting, in a thickness direction, within an area of the molded product where the carrier has been peeled, to remove an outer edge.
